# FASCICULE DE BREVET EUROPEEN

(11) **EP 2 569 593 B1**
(45) Date de publication et mention de la délivrance du brevet: **03.12.2014**
(21) Numéro de dépôt: 11719251.8
(22) Date de dépôt: 10.05.2011
(51) Int. Cl.: G01B 9/02, G01S 17/32, G01S 17/58

(54) **DISPOSITIF DE MESURE OPTIQUE D'UN PARAMÈTRE PHYSIQUE**
VORRICHTUNG ZUR OPTISCHEN MESSUNG EINES PHYSIKALISCHEN PARAMETERS
DEVICE FOR THE OPTICAL MEASUREMENT OF A PHYSICAL PARAMETER

(30) Priorité: 11.05.2010 FR 1053648
(43) Date de publication de la demande: 20.03.2013
(73) Titulaire: Institut National Polytechnique de Toulouse, 31029 Toulouse Cedex 4 (FR)
(72) Inventeur: BERNAL, Olivier, F-31400 Toulouse (FR); BONY, Francis, F-31590 Lavalette (FR); BOSCH, Thierry, F-31400 Toulouse (FR); ZABIT, Usman, Rawalpindi (PK)
(74) Mandataire: Fourcade, Emmanuelle
(86) Numéro de dépôt international: PCT/EP2011/057559
(87) Numéro de publication internationale: WO 2011/141482

(56) Documents cités:
- US-A- 4 928 152
- US-B1- 6 233 045
- NORGIA M ET AL: "New absolute distance measurement technique by self-mixing interferometry in closed loop", INSTRUMENTATION AND MEASUREMENT TECHNOLOGY CONFERENCE, 2004. IMTC 04. PROCEEDINGS OF THE 21ST IEEE COMO, ITALY 18-20 MAY 2004, PISCATAWAY, NJ, USA,IEEE, US, 18 mai 2004 (2004-05-18), pages 216-221VOL.1, XP010735859, DOI: DOI:10.1109/IMTC.2004.1351031 ISBN: 978-0-7803-8248-0
- GUIDO GIULIANI ET AL: "Self-mixing laser diode vibrometer; Self-mixing laser diode vibrometer", MEASUREMENT SCIENCE AND TECHNOLOGY, IOP, BRISTOL, GB, vol. 14, no. 1, 1 janvier 2003 (2003-01-01), pages 24-32, XP020063693, ISSN: 0957-0233, DOI: DOI:10.1088/0957-0233/14/1/304

## Description

La présente invention est relative au domaine des dispositifs optoélectroniques. Plus particulièrement, l'invention concerne un dispositif de mesure optique de déplacement d'une cible.

Il existe de nombreux types de dispositifs de mesure de déplacement, de vibration, de distance,..., d'une cible permettant des mesures dites non destructives, c'est à dire ne détériorant pas la cible sur laquelle elles sont effectuées.

Des méthodes optiques sont souvent utilisées car elles présentent l'avantage d'être sans contact avec la cible et non intrusives. Elles sont basées sur la transmission d'un faisceau lumineux par une source lumineuse laser vers une cible et la mesure des changements des propriétés optiques du faisceau lumineux renvoyé de la cible par des moyens de détection et de mesure adaptés.

Parmi les dispositifs optiques existants, on peut citer entre autre les interféromètres de type Michelson, les interféromètres à fibre optique, les capteurs par triangulation. Cependant, pour ces types de dispositifs, l'utilisation de nombreux composants optiques est nécessaire, ce qui rend difficile la réalisation de capteurs compacts, simples d'utilisation et de faible coût. Ces dispositifs présentent de plus, pour certains, une plage de mesure limitée sur quelques centimètres voire millimètres.

Les dispositifs basés sur le phénomène de rétro-injection optique, généralement connu sous le nom anglo-saxon de self-mixing, offrent en comparaison un système de réalisation compact et flexible, à faible coût.

Ces dispositifs sont simples à réaliser et ne nécessitent qu'une source lumineuse laser émettant un faisceau lumineux de mesure sur la cible dont le déplacement est à mesurer par exemple. Une portion du faisceau de mesure est réfléchie par la cible et réinjectée dans une cavité active de la source laser, produisant des interférences dans la cavité active de la source laser.

Lorsqu'un chemin optique parcouru par le faisceau de mesure issu de la source lumineuse laser et rencontrant la cible varie, par exemple en fonction du déplacement de la cible ou de la variation de l'indice de réfraction du milieu dans lequel se trouve la cible, des fluctuations notamment de la puissance optique émise se produisent, causées par ces interférences. Ces fluctuations sont détectées soit par un photo-détecteur, tel que par exemple une photodiode située sur une face arrière de la source laser, soit directement via une tension de jonction de la source lumineuse laser. Les signaux issus de la photodiode ou de la tension de jonction de la source lumineuse laser sont traités par des moyens de traitement adaptés et l'information relative au déplacement de la cible ou à la variation de l'indice de réfraction du milieu en est déduite. Ainsi la source laser joue à la fois le rôle d'une source lumineuse et d'un micro-interféromètre, sans nécessiter de composants optiques externes. Toutefois, lorsque la cible est placée au-delà de quelques centimètres, une lentille peut être intercalée entre la source lumineuse laser et la cible.

Ces dispositifs par rétro-injection optique présentent ainsi l'avantage d'être auto-alignés, compacts et moins coûteux que par interférométrie traditionnelle.

Cependant, ces dispositifs sont notamment sensibles aux vibrations parasites. Ils nécessitent par conséquent d'être posés sur un support stable et immobile par rapport à la cible, tel que par exemple une table optique, pour garantir la précision de la mesure effectuée. Cette condition d'une part entraîne un coût supplémentaire important et d'autre part est inadaptée pour une utilisation de ces dispositifs en conditions réelles, tels que par exemple l'installation sur des sites industriels.

Le document US4928152 décrit une diode laser à rétro-injection comportant un accéléromètre comme moyen de correction pour les vibrations mécaniques du détecteur. Le document US6233045 décrit une diode laser à rétro-injection comportant des accéléromètres ou des inclinomètres pour corriger les mesures des vibrations du détecteur.

L'invention a pour but de proposer un dispositif de mesure basé sur le phénomène de rétro-injection optique répondant à des contraintes de taille, de performance et de coût rendant son utilisation réaliste en milieu industriel.

A cet effet, la présente invention a pour objet un dispositif de mesure optique d'un paramètre physique. Le dispositif de mesure comporte :
- une source lumineuse laser pour générer un faisceau de mesure en direction d'une cible et pour recevoir le faisceau de mesure réfléchi par ladite cible, ledit faisceau de mesure parcourant un chemin optique dont la variation est fonction du paramètre physique à déterminer, ladite source lumineuse laser comportant une cavité optique,
- un capteur de mouvement de la source lumineuse laser,
- des moyens de calcul du paramètre physique à partir d'un signal mesuré au niveau de la source lumineuse laser et d'un signal mesuré par le capteur de mouvement,
- les moyens de calcul comportant un moyen de calibrage du capteur de mouvement par rapport à la source lumineuse laser, ledit moyen de calibrage comportant un système à gain variable et un déphaseur.

Le chemin optique est défini comme une distance géométrique parcourue par le faisceau lumineux rapportée aux propriétés réfringentes du milieu que traverse le faisceau lumineux, c'est à dire en multipliant cette distance géométrique par l'indice de réfraction du milieu.

Le paramètre physique à déterminer, modifiant le chemin optique du faisceau de mesure est par exemple une variation d'indice de réfraction du milieu dans lequel se trouve la cible, une contrainte (mécanique, thermique,...) appliquée sur une fibre optique située en regard de la source lumineuse laser, et préférentiellement un déplacement de la cible en mouvement selon un axe optique passant par la source lumineuse laser.

La source lumineuse laser émet le faisceau de mesure en direction de la cible, qui en réfléchit une fraction. Le faisceau de mesure réfléchi est réinjecté, en tout ou partie, dans la cavité optique de la source lumineuse laser produisant avec le faisceau de mesure émis des interférences dans ladite cavité.

De préférence, la source lumineuse laser est une diode laser mais l'utilisation de tout autre type de source lumineuse laser, telle que par exemple un laser à gaz, est possible.

Lorsque le chemin optique parcouru par le faisceau de mesure varie, les interférences induites génèrent notamment une variation de la puissance optique du faisceau incident émis par la diode laser.

Le signal mesuré au niveau de la source lumineuse laser est fonction de cette variation de puissance optique du faisceau de mesure. Cette variation est fonction de la variation de chemin optique. Le signal mesuré est par exemple une tension, un courant ou un signal numérique.

Le capteur de mouvement permet avantageusement de mesurer le déplacement relatif aux mouvements de la source lumineuse laser en mode de fonctionnement. Ces mouvements peuvent par exemple être des déplacements de la source lumineuse laser inhérents aux besoins de l'application ou des déplacements parasites dus à des vibrations subies par la source lumineuse laser.

Le capteur de mouvement est un dispositif apte à mesurer le déplacement de la source lumineuse laser en fonctionnement, tels que par exemple un accéléromètre, un gyroscope ou un capteur optique.

Lorsque le capteur de mouvement est un accéléromètre par exemple, il est positionné de préférence aussi près que possible de la source lumineuse laser et solidaire de celle-ci. Lorsque le capteur de mouvement est un capteur sans contact, optique par exemple, celui-ci peut être positionné à distance et son faisceau lumineux dirigé en direction de la source lumineuse laser.

Le signal mesuré par le capteur de mouvement est fonction du déplacement de la source lumineuse laser. Le signal mesuré est par exemple un courant, une tension ou un signal numérique.

Des moyens de calcul permettent ensuite de déterminer le paramètre physique à partir du signal mesuré au niveau de la source lumineuse laser et du signal mesuré par le capteur de mouvement.

Les moyens de calcul comportent :
- un premier moyen de conversion du signal mesuré au niveau de la source lumineuse laser en une mesure de variation de chemin optique, dite mesure de variation de chemin optique totale,
- un second moyen de conversion du signal mesuré par le capteur de mouvement en une mesure du déplacement de la source lumineuse laser, dite mesure de déplacement.

La mesure de la variation de chemin optique totale tient compte à la fois de la mesure de la variation de chemin optique réelle et de la mesure de déplacement.

Dans un exemple de réalisation, les moyens de calibrage consistent en une compensation de l'erreur sur le gain du capteur de mouvement et une synchronisation temporelle entre la chaîne de mesure de la source lumineuse laser et la chaîne de mesure du capteur de mouvement.

Dans un mode de réalisation du dispositif de mesure, les moyens de calibrage sont placés, sur la chaîne de mesure du capteur de mouvement, en sortie du second moyen de conversion.

Dans un mode de réalisation du dispositif de mesure, pour améliorer le signal rapport sur bruit, le dispositif de mesure comporte une photodiode en sortie de la source lumineuse laser, en amont du premier moyen de conversion, et le signal mesuré au niveau de la source lumineuse laser est un signal acquis par la photodiode.

Dans un mode préféré de réalisation du dispositif de mesure, lorsque la source lumineuse laser est une diode laser, la photodiode est une photodiode intégrée dans un même boîtier que la diode laser.

Dans un autre mode de réalisation du dispositif de mesure, lorsque la source lumineuse laser est une diode laser, le signal mesuré au niveau de la diode laser est un signal acquis par amplification de la tension de jonction de ladite diode laser.

Dans un autre mode de réalisation du dispositif de mesure, lorsque la cible est placée à une distance de la source lumineuse laser supérieure à quelques centimètres, le dispositif de mesure comporte une lentille placée sur l'axe optique XX', entre la source lumineuse laser et la cible. La lentille, de préférence convexe, permet de focaliser/collimater le faisceau de mesure. Ladite lentille peut être une lentille adaptative pour une collimation/focalisation automatisée.

Dans un autre mode de réalisation du dispositif de mesure, pour améliorer sa résolution, ledit dispositif de mesure comporte, entre la source lumineuse laser et la cible, un modulateur électro-optique apte à moduler la phase du faisceau de mesure.

Suivant un autre aspect, l'invention concerne un procédé de mesure d'un paramètre physique par une mesure laser.

Le procédé comporte des étapes de :
- émission d'un faisceau de mesure par la source lumineuse laser en direction de la cible,
- mesure au niveau de la source lumineuse laser d'un signal représentatif de la variation de chemin optique totale,
- mesure par le capteur de mouvement d'un signal représentatif du déplacement de la source lumineuse laser, pendant la mesure au niveau de la source lumineuse laser,
- détermination de la variation de chemin optique totale par le premier moyen de conversion, à partir du signal mesuré par la source lumineuse laser,
- détermination du déplacement de la source lumineuse laser par le second moyen de conversion, à partir du signal mesuré par le capteur de mouvement,
- détermination du paramètre physique à partir de la variation de chemin optique totale et du déplacement de la source lumineuse laser,
- étalonnage réalisé par des moyens de calibrage, ladite étape d'étalonnage comprennant une correction de phase et gain entre le signal mesuré par le capteur de movement et le signal représentatif de la variation de chemin optique totale.

La mesure au niveau de la source lumineuse laser du signal représentatif de la variation de chemin optique totale, et la mesure par le capteur de mouvement du signal représentatif du déplacement de la source lumineuse laser sont réalisées de manière synchrone avec une même origine.

L'ordre de mise en oeuvre de l'étape de détermination de la variation de chemin optique totale par le premier moyen de conversion, à partir du signal mesuré au niveau de la source lumineuse laser et de l'étape de détermination du déplacement de la source lumineuse laser par le second moyen de conversion, à partir du signal mesuré par le capteur de mouvement, n'est pas imposé et suivant le procédé, peuvent être réalisées dans l'ordre inverse de l'ordre décrit ou préférentiellement réalisées simultanément sans modifier le résultat desdites étapes.

L'invention est également relative à l'utilisation du dispositif de mesure optique à l'inspection et au contrôle non destructif de matériaux et pièces manufacturés ainsi qu'à leur analyse modale.

L'invention est également relative à l'utilisation du dispositif de mesure optique à la mesure de déplacements et de vibrations d'une cible.

L'invention est également relative à l'utilisation du dispositif de mesure optique à la détection de variation d'un mélange gazeux et/ou liquide.

Parmi d'autres utilisations de ce dispositif de mesure optique, on peut citer par exemple les mesures de déplacements aléatoires de cibles, le suivi de joint/soudure, la détection d'impact, l'optimisation de l'usinage grande vitesse, la mesure de contraintes mécaniques dans les matériaux.

La mise en oeuvre de ce dispositif de mesure entre autre dans les utilisations susnommées est du ressort de l'homme du métier.

Ce dispositif de mesure optique présente aussi l'avantage de pouvoir être utilisé même dans un système embarqué en mouvement.

Dans un mode préféré de réalisation, le dispositif de mesure optique permet la mesure d'un déplacement d'une cible selon un axe XX', comme paramètre physique.

L'invention est également relative à un système pour la mesure de déplacements d'une cible selon N axes, N supérieur ou égal à deux, comportant N dispositifs de mesure optique placés chacun selon un axe.

La description qui va suivre, donnée uniquement à titre d'exemple d'un mode de réalisation de l'invention, est faite en se référant aux figures annexées dans lesquelles :
Figure 1, illustre schématiquement un exemple de dispositif de mesure de déplacement d'une cible, basé sur le phénomène de rétro-injection optique selon l'invention,
Figure 2, illustre un exemple de traitement de signal du dispositif de mesure,
Figure 3, illustre les courbes de déplacement mesuré et reconstruit pour un premier exemple de fonctionnement,
Figure 4, illustre les courbes de déplacement mesuré et reconstruit pour un deuxième exemple de fonctionnement,
Figure 5, illustre les courbes de déplacement mesuré et reconstruit pour un troisième exemple de fonctionnement,
Figure 6, illustre les courbes de déplacement mesuré et reconstruit pour un quatrième exemple de fonctionnement.

L'exemple de réalisation du dispositif de mesure est décrit de manière détaillée dans son application au cas d'une mesure de déplacement d'une cible. Ce choix n'est pas limitatif et l'invention s'applique également à d'autres paramètres physiques, tels que par exemple une variation de l'indice de réfraction optique du milieu, due à une contrainte appliquée sur une fibre optique située devant le laser ou à une variation de mélange gazeux entre le laser et la cible.

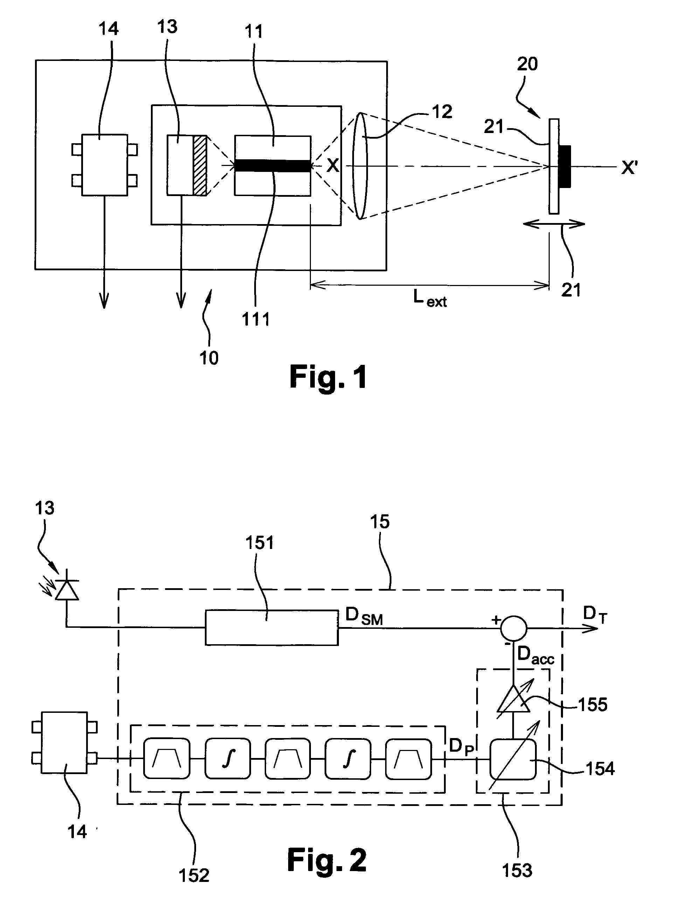

La figure 1 illustre schématiquement un dispositif optique 10 pour la mesure de déplacement d'une cible 20 selon un mode particulier de réalisation de l'invention et basé sur le phénomène de rétro-injection optique.

Le dispositif comporte une source lumineuse laser 11, une lentille 12, un détecteur 13, un capteur de mouvement 14 et des moyens de calcul 15 du déplacement de la cible.

La source lumineuse laser 11, la lentille 12 et la cible 20 sont placées sur un axe optique commun XX'.

La source lumineuse laser 11 est sensible à la rétro-injection optique, elle comporte une cavité optique 111 et est adaptée pour émettre un faisceau optique de mesure, de longueur d'onde λ, selon l'axe optique XX' en direction de la cible 20 et pour recevoir le faisceau de mesure réfléchi.

De préférence, la source lumineuse laser 11 est une diode laser, mais l'utilisation de tout autre type de source lumineuse laser, telle que par exemple un laser à gaz, est possible.

Dans un mode préféré de réalisation, la diode laser 11 est alimentée avec un courant à valeur sensiblement continue dans le temps.

Dans un autre mode de réalisation, la diode laser 11 est alimentée par un courant variable au cours du temps, tel qu'un courant périodique, par exemple de type sinusoïdal ou triangulaire.

Au contraire des interféromètres classiques, il n'est pas obligatoire de stabiliser la diode laser en longueur d'onde au moyen de systèmes d'asservissement entraînant un surcoût, la précision atteignable sans asservissement étant suffisante pour de nombreuses applications nécessitant un dispositif à faible coût.

La diode laser 11 est placée à une distance Lₑₓₜ de la cible.

La lentille 12 est placée sur un chemin optique parcouru par le faisceau optique de mesure et interposée entre la source laser et la cible.

De préférence, la lentille 12 est utilisée pour la mesure de déplacement de cible située pour des distances Lₑₓₜ supérieures à quelques centimètres. Elle n'est généralement pas nécessaire pour des distances Lₑₓₜ inférieures à quelques centimètres.

La lentille 12 est choisie d'une part de sorte à recevoir un faisceau de mesure issu de la diode laser 11 et à collimater/focaliser ledit faisceau de mesure en direction de la cible et d'autre part pour recevoir une fraction du faisceau de mesure réfléchi par la cible et pour le collimater/focaliser vers la cavité interne 111 de la diode laser 11.

La cible 20 est en mouvement, comme indiqué schématiquement à titre d'exemple par la flèche 21, selon l'axe optique XX'.

Le dispositif de mesure 10 selon l'invention est donc adapté à mesurer la projection du déplacement de la cible 20 le long de la direction de l'axe optique XX'.

La cible 20 est adaptée pour recevoir au moins une partie du faisceau de mesure issu de la diode laser et présente une surface 21 pour réfléchir ledit faisceau de mesure.

De préférence, la surface 21 de la cible 20 est sensiblement plane et sensiblement perpendiculaire à l'axe optique XX' afin d'obtenir la meilleure précision possible. Cependant, une surface plane et une perpendicularité par rapport à l'axe optique ne sont pas essentielles pour obtenir une mesure de déplacement de la cible suivant l'invention. D'autres formes de surface peuvent être utilisées dès lors qu'elles réfléchissent au moins une partie du faisceau de mesure vers la cavité optique de la diode laser.

En cas de non perpendicularité du déplacement, la mesure du déplacement de la cible se fera suivant la projection selon l'axe optique XX'.

Dans un exemple de réalisation, la cible 20 peut être une partie d'un objet pour lequel le déplacement doit être mesuré.

Alternativement, la cible 20 peut être séparée de l'objet mais attachée à l'objet, de sorte que la mesure de déplacement de la cible est équivalente à la mesure du déplacement de l'objet.

Ainsi le faisceau de mesure, non collimaté, issu de la diode laser 11, se dirige vers la lentille 12 qui le collimate/focalise vers la cible 20.

La cible 20 réfléchit une fraction du faisceau de mesure.

Le faisceau de mesure réfléchi, après passage par la lentille 12, est réinjecté dans la cavité optique 111 de la diode laser 11 créant avec le faisceau de mesure émis par la diode laser des interférences.

Lorsque la cible 20 est en déplacement selon l'axe optique XX', la longueur de chemin optique parcourue par le(s) faisceau(x), c'est-à-dire la distance aller-retour entre la diode laser 11 et la cible 20, varie, les interférences dépendantes du déplacement de la cible génèrent une variation de la puissance optique du faisceau de mesure émis par la diode laser 11.

Un détecteur de mesure 13 détecte la variation de la puissance optique du faisceau de mesure émis par la diode laser et la convertit en un signal, dit signal SM, comportant les interférences dépendantes du déplacement de la cible. Ce signal SM peut être par exemple, un signal d'intensité de courant, de tension, de puissance, un signal numérique.

Le détecteur de mesure est de préférence une photodiode 13. Dans un exemple préféré de réalisation, la photodiode 13 est une photodiode intégrée dans un même boîtier que la diode laser 11 et située sur une face arrière de la diode laser. Cette photodiode, servant habituellement à asservir la puissance d'émission de la diode laser, est mise à contribution pour détecter les variations de la puissance optique de la diode laser, induites par le phénomène de rétro-injection optique.

En sortie de la photodiode, comme illustré sur la figure 2, un moyen de conversion, dit premier moyen de conversion 151, traite le signal SM issu de la photodiode et le convertit en une mesure de déplacement, dite mesure de déplacement total D_{SM}.

Cette mesure de déplacement total D_{SM} tient compte de la mesure de déplacement de la cible et de déplacement dû aux mouvements de la diode laser 11 lorsqu'elle est en fonctionnement.

Dans un exemple de réalisation, le premier moyen de conversion 151 utilise une méthode de comptage de franges pour reconstruire le déplacement total D_{SM} à partir du signal SM. La précision de cette méthode est liée à la longueur d'onde de la diode laser utilisée.

Dans un autre exemple de réalisation, le premier moyen de conversion 151 utilise une méthode de dépliement de phase pour reconstruire le déplacement total D_{SM} à partir du signal SM.

Les deux méthodes énoncées ci-avant, comptage de franges et dépliement de phase, sont des méthodes connues en tant que telles et ne seront donc pas décrites.

Le premier moyen de conversion 151 peut être analogique ou numérique suivant le signal SM.

Le dispositif de mesure 10 comporte en outre un capteur de mouvement 14. Dans un exemple préféré de réalisation, ce capteur de mouvement est un accéléromètre disposé à proximité de la diode laser 11, de préférence solidaire de la diode laser. Selon l'invention, l'accéléromètre 14 est avantageusement utilisé pour mesurer le déplacement dû aux mouvements de la diode laser 11.

L'accéléromètre 14 peut être par exemple de type optique ou piézoélectrique. Dans un exemple préféré de réalisation, l'accéléromètre est un accéléromètre à base de systèmes microélectromécaniques, dit MEMS. Les accéléromètres à base de MEMS sont de faible encombrement et permettent avantageusement de positionner ledit accéléromètre au plus proche de la source laser.

Le déplacement dû aux mouvements de la diode laser est mesuré indirectement par la mesure de l'accélération de la source laser par l'accéléromètre.

En sortie de l'accéléromètre, un moyen de conversion, dit second moyen de conversion 152, traite un signal, dit signal d'accélération, issu de l'accéléromètre et le convertit en une mesure de déplacement de la diode laser, dite mesure de déplacement Dₚ.

Le signal d'accélération peut être par exemple, un signal de tension, un signal numérique.

Dans un exemple de second moyen de conversion, comme illustré sur la figure 2, ledit second moyen de conversion 152 utilise une méthode de double intégration du signal d'accélération pour reconstruire le déplacement de la diode laser à partir du signal d'accélération.

Le second moyen de conversion 152 peut être analogique ou numérique suivant le signal d'accélération.

En sortie du second moyen de conversion 152, un moyen de calibrage 153 de l'accéléromètre 14 par rapport à la diode laser 11 calibre la mesure de déplacements de la diode laser 11.

Comme illustré sur la figure 2, ledit moyen de calibrage comporte un système à gain variable 154 pour permettre de compenser les erreurs de gain de l'accéléromètre lui-même et un déphaseur 155 pour synchroniser les deux chaînes de mesure, à savoir la chaîne de mesure de la diode laser et la chaîne de mesure de l'accéléromètre.

Le déplacement réel reconstitué D_{T} de la cible 20 est ensuite déterminé par une soustraction entre la mesure de déplacement total D_{SM} obtenue par la diode laser soumise à un mouvement et la mesure calibrée de déplacement D_{acc} obtenue à partir de l'accéléromètre.

Le premier et deuxième moyen de conversion 151, 152, ainsi que le moyen de calibrage 153 constituent les moyens de calculs 15.

Le dispositif de mesure 10 selon l'invention permet de reconstituer la mesure du déplacement de la cible D_{T}. Ce dispositif peut être utilisé avantageusement sur une grande plage de mesure. En effet, la plage de mesure peut être limitée par la demi-longueur de cohérence de la diode laser. La plage de mesure peut aller jusqu'à plusieurs mètres, suivant la source lumineuse laser choisie.

Il est important de noter ici que, afin de corriger les déplacements parasites de la source laser, on soustrait, dans le présent procédé, le déplacement mesuré obtenu par l'accéléromètre dans le sens du faisceau laser.

Non seulement le gain, mais aussi la phase du signal de déplacement reconstitué à partir du signal d'accélération, sont corrigés pour tenir compte des déphasages introduits par le traitement du signal de self-mixing et du signal d'accélération. Ces corrections permettent d'obtenir une bonne précision de mesure,

Puisque les étapes du traitement du signal effectué sur chacun des deux canaux (accéléromètre et canaux d'auto-mélange) sont de nature non-linéaire (filtrage, intégration, dérivation etc.), les phases des signaux finals sur les deux canaux sont non-nulles et varient sur toute la largeur de bande passante du système.

Par conséquent, une simple soustraction directe des deux signaux finals par l'homme du métier ne peut permettre d'obtenir une évaluation correcte du déplacement de la cible.

Le présent procédé comporte ainsi des étapes complémentaires d'étalonnage et de correction des phases respectives des signaux.

En fait, une correction de phase se révèle plus importante qu'une correction de gain, une différence de phase importante entre les deux signaux finals conduisant à un très mauvais signal obtenu après soustraction.

La correction de phase entre les deux signaux finals peut être obtenue par différents moyens, dont trois sont cités ci-dessous à titre d'exemple non limitatif :
1) Un filtre analogique passe-tout peut être utilisé, avec une relation de phase personnalisée, conçue pour corriger la phase de l'un des deux signaux finals à l'égard de l'autre signal.
2) Un filtre numérique avec une relation de phase sur-mesure peut être utilisée pour faire correspondre la phase d'un signal par rapport à l'autre. Une telle solution pourrait impliquer un coût supplémentaire de conversions analogique-numérique et numérique-analogique. Cependant, une relation de phase très précise peut être réalisée sur des données numériques.
3) Une analyse spectrale des deux derniers signaux permet d'obtenir la relation entre ces deux signaux. Une correction peut ensuite être réalisée par la modification de ces spectres de manière à ce que les signaux résultants soient en phase

Toutefois cette correction de gain et de phase n'est pas suffisante si l'on souhaite, comme c'est le cas dans le présent procédé, avoir des résolutions proches de la résolution intrinsèque au capteur laser. En effet, deux phénomènes distincts peuvent engendrer des erreurs:
- le bruit de l'accéléromètre,
- le couplage entre les divers axes de l'accéléromètre.

Considérons dans un premier temps le bruit de l'accéléromètre. Lors du processus de double intégration nécessaire pour obtenir le signal de déplacement à partir du signal d'accélération, le bruit issu du capteur d'accélération subit lui aussi cette double intégration.

C'est pourquoi, il résulte une augmentation du bruit du signal de déplacement ainsi reconstitué en 1/f2 ou f désigne la fréquence considérée.

Pour éviter les dérives à basses fréquences du capteur (random walk) résultantes, le présent procédé comporte une étape de filtrage, à l'aide d'un passe haut d'ordre élevé; du signal issu de l'accéléromètre.

En général, la fréquence de coupure basse de ce filtre est fixée par l'erreur maximale qui peut être toléré par le système.

Par exemple, avec un accéléromètre linéaire de type connu sous le nom commercial de LIS344ALH (marque déposée) de ST (marque déposée), cette fréquence est de 20Hz pour obtenir une correction avec une résolution égale à celle du self-mixing soit 50nm. Celle-ci serait de 1 Hz pour un dispositif de type connu sous le nom commercial de SF1500 (marque déposée) de Colibrys (marque déposée).

En ce qui concerne maintenant le couplage entre les divers axes de l'accéléromètre, ce couplage peut être dû à un mauvais alignement, soit extrinsèque (vis-à-vis du capteur laser), soit intrinsèque (vis-à-vis des axes internes de l'accéléromètre). En général, le couplage est inférieur à 2%. Il est à noter que ce couplage est observé, que l'accéléromètre dispose d'un seul axe, de deux axes ou de trois axes.

Aussi, si la perturbation (vibration parasite) qui s'applique sur le laser est majoritairement orientée suivant un axe perpendiculaire à celui du faisceau laser, l'information fournit par l'accéléromètre est compromise.

Le procédé ici décrit à titre d'exemple non limitatif comporte ainsi une étape de calibrage de l'accéléromètre vis-à-vis du couplage entre les axes est nécessaire pour pouvoir garantir la résolution souhaitée.

Afin d'illustrer le déplacement reconstitué de la cible à partir du dispositif de mesure selon l'invention, de nombreuses expériences ont été réalisées et sont synthétisées ci dessous sur la forme de quatre exemples.

Pour toutes les expériences :
- la source lumineuse laser est une diode laser de type connu sous le nom commercial de HL 7851 G (marque déposée) d'Hitachi (marque déposée) émettant à une longueur d'onde λ de 785nm avec photodiode intégrée. La diode laser est alimentée par un courant d'injection constante de 30mA, et a une puissance de sortie maximale de 50mW,
- le capteur d'accélération est un accéléromètre de type connu sous le nom commercial de ADXL311 (marque déposée) de Analog Devices (marque déposée) avec une résolution de 300µg/√Hz et une bande passante de 5kHz,
- les vibrations/déplacements susceptibles par exemple d'être parasites pour la diode laser sont générés par un pot vibrant auquel la diode laser et l'accéléromètre sont solidaires,
- la cible est positionnée à une distance de 45cm de la diode laser, et le déplacement de celle-ci est généré par un capteur piézoélectrique de type P753.2CD de Physik Instrumente^{®}. Ce capteur piézoélectrique est couplé à un capteur capacitif pour mesurer directement le déplacement du capteur piézoélectrique avec une résolution de 2nm.

Pour obtenir les coefficients de calibrage sur le gain et la phase du moyen de calibrage, une phase de calibrage du dispositif de mesure selon un mode particulier de l'invention est utilisée dans cet exemple de réalisation afin d'obtenir une meilleure précision. Pendant cette phase de calibrage, seule la diode laser se déplace, dans cet exemple, à l'aide du pot vibrant, tandis que la cible est immobile. Quatre séries de mesures ont été réalisées entre 20Hz et 400Hz par pas de 20Hz. Les signaux extraits de l'accéléromètre et de la diode laser sont comparés pour obtenir les coefficients de calibrage de gain et de phase et sont stockés dans une table de valeur. Après cette phase de calibrage, l'erreur mesurée sur la phase est inférieure à 2° et l'erreur mesurée sur le gain est inférieure à 3%.

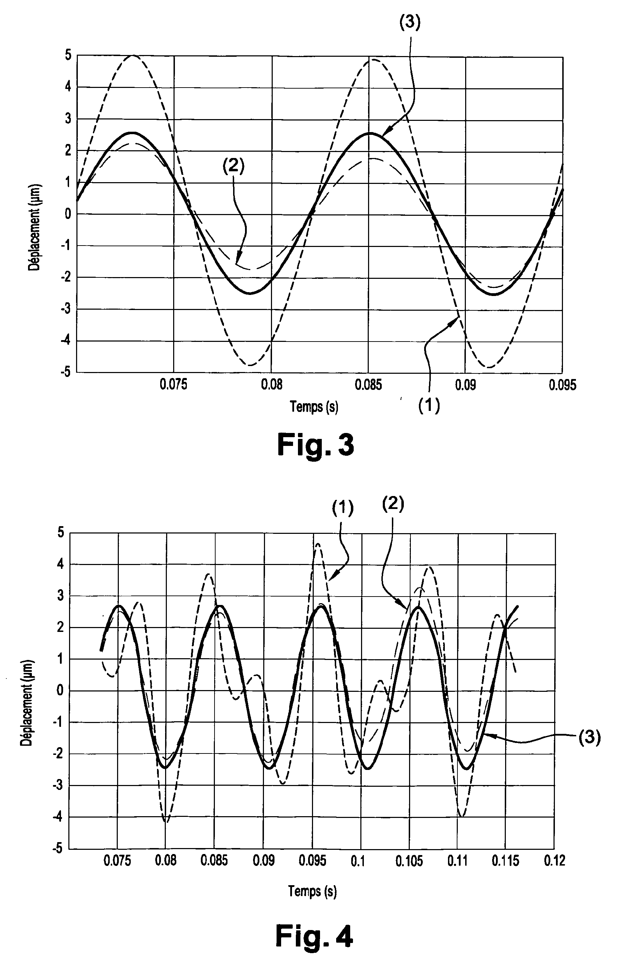

Quatre expériences sont maintenant présentées. Les résultats obtenus sont illustrés respectivement figures 3, 4, 5 et 6. Pour chaque figure :
- la courbe numérotée 1 illustre le signal de déplacement total, reconstruit à partir des signaux obtenus par la diode laser,
- la courbe numérotée 2 illustre le signal de déplacement réel, reconstruit à partir des signaux obtenus par la diode laser et par l'accéléromètre,
- la courbe numérotée 3 illustre le signal de déplacement de la cible, c'est la courbe de référence.

Exemple 1 : la cible et le pot vibrant vibrent à la même fréquence de manière sinusoïdale.

Dans ce premier exemple, le pot vibrant et la cible vibrent à une fréquence identique de 81 Hz, avec une amplitude de signal de 3,5µm et 2.5µm respectivement.

Les résultats sont obtenus sur la figure 3.

On constate que pour la courbe 1, on obtient une amplitude de déplacement erronée de 5µm, tandis que pour la courbe 2, on est proche de la courbe 3.

Ce premier exemple permet de montrer que le dispositif de mesure suivant l'invention permet de reconstituer le déplacement réel de la cible même en présence d'une vibration de même fréquence. Ceci peut fréquemment arriver dans le cas d'un couplage mécanique indésirable entre le dispositif de mesure et la cible vibrante.

Exemple 2: la cible et le pot vibrant vibrent à des fréquences différentes de façon sinusoïdale.

Dans ce deuxième exemple, le pot vibrant vibre à une fréquence de 167Hz avec une amplitude de signal de 2µm et la cible vibre à une fréquence de 97Hz avec une amplitude de signal de 2,5µm.

Les résultats sont obtenus sur la figure 4.

On constate, dans ce deuxième exemple, que pour la courbe 1, on obtient un signal de déplacement distordu, tandis que pour la courbe 2, on est proche de la courbe 3.

Exemple 3 : la cible et le pot vibrant vibrent de façon arbitraire.

Le pot vibrant vibre à une combinaison de fréquences de 46Hz-92Hz-194Hz-276Hz.

La cible vibre à une combinaison de fréquences de 26Hz-104Hz-216Hz.

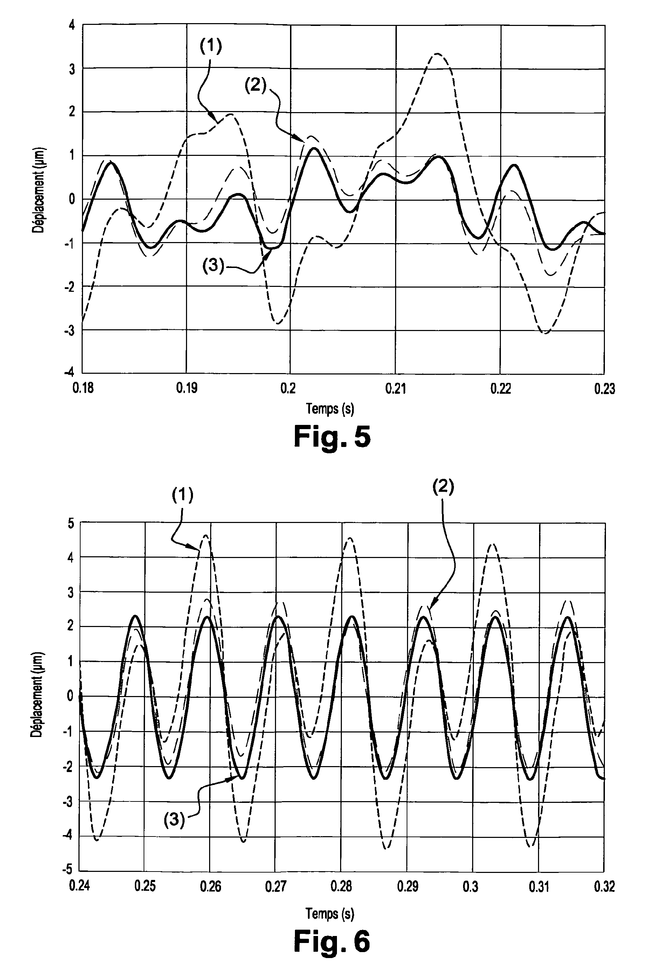

Les résultats sont obtenus sur la figure 5.

On constate, dans ce troisième exemple, que pour la courbe 1, on obtient un signal de déplacement très distordu avec de fortes amplitudes, tandis que pour la courbe 2, on est à nouveau proche de la courbe 3 de référence.

Exemple 4 : la cible vibre à une fréquence fixe de manière sinusoïdale et le pot vibrant vibre de façon arbitraire.

Le pot vibrant vibre à une combinaison de fréquences de 46Hz-92Hz-194Hz-276Hz.

La cible vibre à une fréquence de 91 Hz avec une amplitude de 2,3 µm. Les résultats sont obtenus sur la figure 6.

On constate, dans ce quatrième exemple, que pour la courbe 1, on obtient un signal de déplacement distordu et une forte amplitude, tandis que pour la courbe 2, on est à nouveau proche de la courbe 3 de référence.

Le dispositif de mesure suivant l'invention permet avantageusement de réduire l'erreur de mesure de déplacement de la cible par un capteur à retro-injection optique causée par les déplacements de la diode laser.

Le dispositif de mesure suivant l'invention est un dispositif simple à réaliser, peu encombrant, auto-aligné et robuste pour la mesure de déplacement avec une précision de 300 nm pour la présente réalisation, avec l'accéléromètre de type ADXL311 de Analog Devices. Il présente également l'avantage d'être d'un coût abordable et transportable en milieu industriel.

Dans une variante de réalisation de l'invention, il est possible d'envisager un système de mesure formé par l'association d'au moins deux dispositifs de mesure optique 10, positionnés selon des axes différents, pour la mesure conjointe de déplacements transverses de la cible 20.

Dans un exemple de réalisation, lorsque l'ensemble est formé de deux dispositifs de mesure optique 10 positionnés selon deux axes différents, le déplacement de la cible 20 est alors déterminé bidimensionnellement, dans un plan formé par les deux axes.

Dans un autre exemple de réalisation, lorsque l'ensemble est formé de trois dispositifs de mesure optique 10 positionnés selon trois axes différents, le déplacement de la cible 20 est déterminé tridimensionnellement.

## Revendications

1. Dispositif de mesure optique (10) d'un paramètre physique comportant :
- une source lumineuse laser (11) pour générer un faisceau de mesure en direction d'une cible (20) et pour recevoir le faisceau de mesure réfléchi par ladite cible, ledit faisceau de mesure parcourant un chemin optique dont la variation est fonction du paramètre physique à déterminer, et ladite source lumineuse laser comportant une cavité optique (111), et des moyens de mesure du faisceau de mesure réfléchi par la cible,
- un capteur de mouvement (14) de la source lumineuse laser (11),
- des moyens de calcul (15) du paramètre physique à partir d'un signal mesuré au niveau de la source lumineuse laser (11) et d'un signal mesuré par le capteur de mouvement (14),
**caractérisé en ce que** les moyens de calcul (15) comportent un moyen de calibrage (153) du capteur de mouvement (14) par rapport à la source lumineuse laser (11), ledit moyen de calibrage comporte un système à gain variable (154) et un déphaseur (155).

2. Dispositif de mesure selon la revendication 1 dans lequel les moyens de calcul (15) comportent un premier moyen de conversion (151) du signal mesuré au niveau de la source lumineuse laser (11) en une mesure de variation de chemin optique totale et un second moyen de conversion (152) du signal mesuré par le capteur de mouvement (14) en une mesure de déplacement de la source lumineuse laser.

3. Dispositif de mesure selon l'une des revendications précédentes dans lequel le capteur de mouvement (14) est un accéléromètre.

4. Dispositif de mesure selon l'une des revendications 2 à 3 comportant une photodiode (13) en sortie de la source lumineuse laser (11), en amont du premier moyen de conversion (151).

5. Dispositif de mesure selon l'une des revendications précédentes dans lequel la source lumineuse laser (11) est une diode laser.

6. Procédé de mesure d'un paramètre physique à partir du dispositif de mesure optique conforme à l'une des revendications 1 à 5 comportant les étapes de :
- émission d'un faisceau de mesure par la source lumineuse laser (11) en direction de la cible (20),
- mesure au niveau de la source lumineuse laser (11) d'un signal représentatif de la variation de chemin optique totale,
- mesure par le capteur de mouvement (14) d'un signal représentatif du déplacement de la source lumineuse laser (11), pendant la mesure de la source lumineuse laser,
- détermination de la variation de chemin optique totale par le premier moyen de conversion (151), à partir du signal mesuré au niveau de la source lumineuse laser (11),
- détermination du déplacement de la source lumineuse laser par le second moyen de conversion (152), à partir du signal mesuré par le capteur de mouvement (14),
- détermination du paramètre physique à partir de la variation de chemin optique totale et du déplacement de la source lumineuse laser,
**caractérisé en ce que** le procédé comporte une étape d'étalonnage réalisée par les moyens de calibrage (153), ladite étape d'étalonnage comprenant une correction de phase et gain entre le signal mesuré par le capteur de mouvement (14) et le signal représentatif de la variation de chemin optique totale.

7. Utilisation du dispositif de mesure optique selon l'une des revendications 1 à 5 à l'inspection et au contrôle non destructif de matériaux et pièces manufacturés.

8. Utilisation du dispositif de mesure optique selon l'une des revendications 1 à 5 à la mesure de déplacements et de vibrations d'une cible.

9. Utilisation du dispositif de mesure optique selon l'une des revendications 1 à 5 à la détection de variation d'un mélange gazeux et/ou liquide.

10. Système embarqué comportant un dispositif selon l'une des revendications 1 à 5.

11. Dispositif de mesure optique (10) selon la revendication 1, dans lequel le paramètre physique mesuré est le déplacement de la cible selon un axe XX'.

12. Système pour la mesure de déplacements d'une cible selon N axes, N supérieur ou égal à deux, comportant N dispositifs de mesure optique conformes à la revendication 11.

## Patentansprüche

1. Optische Vorrichtung (10) zum Messen eines physikalischen Parameters, die Folgendes umfasst:
- eine Laserlichtquelle (11), um ein Messstrahlenbündel in Richtung eines Ziels (20) zu erzeugen und um das von dem Ziel reflektierte Messstrahlenbündel zu empfangen, wobei das Messstrahlenbündel einen optischen Weg durchläuft, dessen Veränderung eine Funktion des zu bestimmenden physikalischen Parameters ist, und wobei die Laserlichtquelle einen optischen Resonator (111) und Mittel zum Messen des von dem Ziel reflektierten Messstrahlenbündels enthält,
- einen Sensor (14) für die Bewegung der Laserlichtquelle (11) und
- Mittel (15) zum Berechnen des physikalischen Parameters anhand eines auf Seiten der Laserlichtquelle (11) gemessenen Signals und eines durch den Bewegungs-sensor (14) gemessenen Signals,
**dadurch gekennzeichnet, dass** die Rechenmittel (15) ein Mittel (153) zum Kalibrieren des Bewegungssensors (14) in Bezug auf die Laserlichtquelle (11) umfassen, wobei das Kalibrierungsmittel ein System (154) mit veränderlichem Verstärkungsfaktor und einen Phasenschieber (155) umfasst.

2. Messvorrichtung nach Anspruch 1, wobei die Rechenmittel (15) ein erstes Mittel (151) zum Umsetzen des auf Seiten der Laserlichtquelle (11) gemessenen Signals in eine Messung der Veränderung des gesamten optischen Wegs und ein zweites Mittel (152) zum Umsetzen des durch den Bewegungssensor (14) gemessenen Signals in eine Messung der Verlagerung der Laserlichtquelle umfassen.

3. Messvorrichtung nach einem der vorhergehenden Ansprüche, wobei der Bewegungssensor (14) ein Beschleunigungsmesser ist.

4. Messvorrichtung nach einem der Ansprüche 2 bis 3, die am Ausgang der Laserlichtquelle (11) stromaufseitig des ersten Umsetzungsmittels (151) eine Photodiode (13) umfasst.

5. Messvorrichtung nach einem der vorhergehenden Ansprüche, wobei die Laserlichtquelle (11) eine Laserdiode ist.

6. Verfahren zum Messen eines physikalischen Parameters anhand der optischen Messvorrichtung nach einem der Ansprüche 1 bis 5, das die folgenden Schritte umfasst:
- Aussenden eines Messstrahlenbündels durch die Laserlichtquelle (11) in Richtung des Ziels (20),
- Messen auf Seiten der Laserlichtquelle (11) eines die Veränderung des gesamten optischen Wegs repräsentierenden Signals,
- Messen durch den Bewegungssensor (14) eines die Verlagerung der Laserlichtquelle (11) während der Messung der Laserlichtquelle repräsentierenden Signals,
- Bestimmen der Veränderung des gesamten optischen Wegs durch das erste Umsetzungsmittel (151) anhand des auf Seiten der Laserlichtquelle (11) gemessenen Signals,
- Bestimmen der Verlagerung der Laserlichtquelle durch das zweite Umsetzungsmittel (152) anhand des durch den Bewegungssensor (14) gemessenen Signals und
- Bestimmen des physikalischen Parameters anhand der Veränderung des gesamten optischen Wegs und der Verlagerung der Laserlichtquelle,
**dadurch gekennzeichnet, dass** das Verfahren einen Eichungsschritt umfasst, der von den Kalibrierungsmitteln (153) ausgeführt wird, wobei der Eichungsschritt eine Korrektur der Phase und des Verstärkungsfaktors zwischen dem von dem Bewegungssensor (14) gemessenen Signal und dem die Veränderung des gesamten optischen Wegs repräsentierenden Signal umfasst.

7. Verwendung der optischen Messvorrichtung nach einem der Ansprüche 1 bis 5 für die nicht destruktive Untersuchung und Kontrolle hergestellter Materialien und Teile.

8. Verwendung der optischen Messvorrichtung nach einem der Ansprüche 1 bis 5 bei der Messung von Verlagerungen und von Vibrationen eines Ziels.

9. Verwendung der optischen Messvorrichtung nach einem der Ansprüche 1 bis 5 bei der Detektion der Veränderung eines gasförmigen und/oder flüssigen Gemisches.

10. Bordinternes System, das eine Vorrichtung nach einem der Ansprüche 1 bis 5 umfasst.

11. Optische Messvorrichtung (10) nach Anspruch 1, wobei der gemessene physikalische Parameter die Verlagerung des Ziels längs einer Achse XX' ist.

12. System für die Messung von Verlagerungen eines Ziels längs N Achsen, wobei N größer oder gleich zwei ist, das N optische Messvorrichtungen nach Anspruch 11 umfasst.

## Claims

1. Measuring device (10) for the optical measurement of a physical parameter, comprising:
- a laser light source (11) for generating a measurement beam in the direction of a target (20) and for receiving the measurement beam reflected by said target, said measurement beam tracing an optical path the variation of which is a function of the physical parameter to be determined, and said laser light source comprising an optical cavity (111) and means for measuring the measurement beam reflected by the target;
- a motion sensor (14) of the laser light source (11); and
- means (15) for calculating the physical parameter from a signal measured at the laser light source (11) and a signal measured by the motion sensor (14),
**characterised in that**, the calculating means (15) comprising a means (153) for calibrating the motion sensor (14) relative to the laser light source (11), said calibrating means comprises a variable gain system (154) and a phase shifter (155).

2. Measuring device according to Claim 1, wherein the calculating means (15) comprises a first means (151) for converting the signal measured at the laser light source (11) into a measurement of total optical path variation, and a second means (152) for converting the signal measured by the motion sensor (14) into a measurement of the displacement of the laser light source.

3. Measuring device according to one of the preceding claims, wherein the motion sensor (14) is an accelerometer.

4. Measuring device according to one of Claims 2 to 3, comprising a photodiode (13) at the output of the laser light source (11), upstream of the first converting means (151).

5. Measuring device according to one of the preceding claims, wherein the laser light source (11) is a laser diode.

6. Method for measuring a physical parameter with the optical measuring device according to one of Claims 1 to 5, comprising steps of:
- emission of a measurement beam by the laser light source (11) in the direction of the target (20);
- measurement at the laser light source (11) of a signal representative of the total optical path variation;
- measurement by the motion sensor (14) of a signal representative of the displacement of the laser light source (11), during the measurement of the laser light source;
- determination of the total optical path variation by the first converting means (151), from the signal measured at the laser light source (11);
- determination of the displacement of the laser light source by the second converting means (152), from the signal measured by the motion sensor (14); and
- determination of the physical parameter from the total optical path variation and the displacement of the laser light source,
**characterised in that** the method comprises a calibrating step carried out by the calibrating means (153), said calibrating step comprising a correction of phase and gain between the signal measured by the motion sensor (14) and the signal representative of the total optical path variation.

7. Use of the optical measuring device according to one of Claims 1 to 5 in inspection and nondestructive testing of manufactured equipment and parts.

8. Use of the optical measuring device according to one of Claims 1 to 5 to measure displacements and vibrations of a target.

9. Use of the optical measuring device according to one of Claims 1 to 5 to detect variation in a gaseous and/or liquid mixture.

10. On-board system comprising a device according to one of Claims 1 to 5.

11. Optical measuring device (10) according to Claim 1, wherein the physical parameter measured is the displacement of the target along an axis XX'.

12. System for measuring displacements of a target along N axes, N being higher than or equal to two, comprising N optical measuring devices according to Claim 11.
